# EUROPEAN PATENT SPECIFICATION

(11) **EP 0 593 588 B1**
(45) Date of publication and mention of the grant of the patent: **26.03.1997**
(21) Application number: 92914575.3
(22) Date of filing: 08.07.1992
(51) Int. Cl.: H02H 3/087, H02H 9/02, H03K 17/08, H03K 17/785

(54) **CIRCUIT PROTECTION ARRANGEMENT**
SCHUTZEINRICHTUNG FÜR SCHALTUNG
AGENCEMENT DE PROTECTION DE CIRCUIT

(30) Priority: 08.07.1991 GB 9114717
(43) Date of publication of application: 27.04.1994
(73) Proprietor: RAYCHEM LIMITED, London EC4A 1NH (GB)
(72) Inventor: PRYOR, Dennis, Malcolm Sandford House, Wiltshire SN1 4ER (GB); CHALLIS, Michael, Wiltshire SN3 3TH (GB)
(74) Representative: Benson, John Everett
(86) International application number: GB9201237
(87) International publication number: WO9301639

(56) References cited:
- EP-A- 0 446 724
- DE-A- 2 811 696
- DE-A- 3 725 390
- US-A- 4 110 809
- US-A- 4 533 970
- US-A- 4 603 234

## Description

This invention relates to arrangements and devices for protecting electrical circuits from overcurrents, for example from overcurrents caused by equipment faults, electrostatic discharge or other threats.

One circuit protection arrangement of relatively simple form is described in German Patent Application No. 37 25 390 dated 31st July 1987 to Wickmann Werke GmbH. This arrangement comprises a series switching transistor that controls the circuit current and a control transistor that controls the base or gate voltage of the switching transistor. The base or gate voltage of the control transistor is set by a voltage divider that spans the switching transistor, so that, if the arrangement experiences an overcurrent, the control transistor will be biased into conduction and will turn the switching transistor OFF. Although this arrangement is particularly simple, it suffers from the disadvantage that in normal operation there will always be a significant voltage drop across the arrangement before it will conduct current, this voltage drop being due to the base-emitter junction voltage of the switching transistor added to the voltage drop across the base resistor in the case of bipolar arrangements. In the case of arrangements based on enhancement mode FETs, the voltage drop will be due to the threshold voltage of the switching transistor. The voltage drop prevents this form of circuit protection arrangement being used in a number of applications and can lead to heat generation problems in high current applications.

EP-A-0446724 discloses a method of providing a substantially constant current from a voltage source. A depletion mode transistor is connected to a network of resistors.

According to one aspect, the present invention provides an arrangement that exhibits a foldback characteristic and that is intended to be series connected in a line of an electrical circuit for protecting the circuit from an overcurrent, which comprises a depletion mode FET that switches the line current and will bias the gate of the FET in response to the voltage difference across the resistance in order to switch the FET off when the arrangement is subjected to an overcurrent in the line, the arrangement being a two terminal arrangement or one which a third terminal switches on when an overcurrent is experienced in order to shunt the current across a load connected to the circuit or to shunt the current to an earth terminal.

The invention has the advantage that, because the series connected FET is normally in the on state there is no initial voltage drop across the arrangement before it becomes conductive so that the arrangement can be substantially linear. The arrangement according to the invention exhibits a "foldback" characteristic , that is to say, one in which the current that passes through the arrangement increases with increasing voltage difference across it until a certain voltage, referred to as the threshold voltage, is reached whereupon the current through the device decreases to a lower value. Normally the ratio of the maximum leakage current of the device in its off state to the maximum current of the device in its on state (trip current) is not more than 0.5, more preferably not more than 0.1 and especially not more than 0.01. In many cases the ratio can be lower than 10⁻⁴ It is possible, depending on the mechanism of operation of the device that biases the FET, for the arrangement to have a "slow" or a "fast" foldback characteristic. If the arrangement switches quickly from its on state to its off state, for example in less than 100 ms, then it can be said to exhibit a fast foldback characteristic, whereas if the transition between the on state and the off state takes longer it can be said to exhibit a slow foldback characteristic. Whichever characteristic is preferred will depend on the application of the circuit. For example an arrangement that exhibits a fast foldback characteristic will generally let through less energy to the load when subjected to a current transient, whereas arrangements exhibiting slower foldback characteristics may be preferred if the circuit has a load having a significant inductance or if the arrangement needs to be insensitive to short current transients due, for example to equipment being switched on. The switching speed of the arrangement may be altered by including a capacitor and/or a resistor between the source and gate of the FET. Including a small capacitor will slow the switching speed of the arrangement while including a resistor will decrease the abruptness of the switching of the arrangement as a function of the voltage across the FET. Normally a parallel combination of a capacitor and resistor will be employed to allow the capacitor to discharge through the resistor.

The term "depletion mode FET" as used herein is intended to include any FET that is normally in the on state and which will switch off only when the gate is biased. Thus, for example the term includes junction FETs, depletion mode MOSFETS and the like. Depletion mode MOSFETS will normally be employed for relatively high power applications in d.c. circuits or where an a.c. signal is superimposed on a d.c. offset so that there is no reverse current. JFETs, however, may be employed for a.c. signal lines in general. Normally arrangements employing a single JFET will only be able to handle relatively small currents, eg. up to 50 mA (although it is now possible to purchase JFETs having a current rating of 700 mA). However, more than one FET may be placed in parallel with their gates connected to a common control device in order to increase the current rating of the arrangement.

As stated above, the control device that biases the gate of the FET does so in response to the voltage drop that occurs across a resistance in the line. Although it is possible, at least in the broadest aspect of the invention, for the line to include a separate series resistance that causes the voltage drop, it is preferred for the series resistance to be provided at least in part by the FET itself so that the device is connected across the FET. Most preferably the resistance is provided entirely by the FET. In this case it is possible for the arrangement to include no resistive components series connected in the line other than the FET.

One form of control device that may be employed is a negative voltage generator or dc-dc converter. Such devices will in general lead to an arrangement that exhibits foldback characteristics with the maximum leakage current normally being not more than 0.1 times the trip current and typically about 0.01 times the trip current.

Alternatively an opto-electronic coupling arrangement may be employed as the control device. Such an arrangement may comprise a light source that is powered by the voltage drop in the line and which is optically coupled to a photovoltaic element which is connected to the gate of the FET. The light source may generate visible or invisible radiation. It may for example comprise a light-emitting diode, an electroluminescent device or a fluorescent device, while the photovoltaic device may comprise a photodiode connected in the photovoltaic mode.

Although the arrangement described above is a two terminal arrangement, it is possible also to form three terminal arrangements according to the invention where the third terminal switches on when an overcurrent is experienced in order to shunt the current across the load or to the earth terminal. Such arrangements can advantageously be formed so that they do not draw power from the circuit supply line. The third (shunt) terminal may be triggered electrically to shunt the overcurrent, but in the case of arrangements that employ opto-electronic couplers the third terminal is preferably triggered optically. For example, the third terminal may include an opto-triac that is triggered by the control device.

Five terminal protection arrangements for protecting a pair of lines, as commonly used in the telephone protection industry, may be formed employing a pair of overcurrent protection devices according to the invention which can employ either two devices for shunting the overcurrent to the earth terminal, or a single shunting device across the lines. In the case of optically coupled arrangements the light source in either of the overcurrent protection devices can be used to trigger all the protection components of the arrangement, thus comprehensively protecting the load.

Preferably all components of the arrangement take their power from the current in the lines so that no separate power supply is needed.

Several arrangements in accordance with the invention will now be described by way of example with reference to the accompanying drawings, in which:
- Figure 1: is a circuit diagram of one arrangement in accordance with the invention;
- Figure 2: is a circuit diagram of a modification of the arrangement of Figure 1 which can be employed in a.c. circuits;
- Figure 3: is a circuit diagram of a form of another arrangement that employs an optoelectronic coupler to control the FET;
- Figure 4: is a circuit diagram of a three-terminal arrangement which is a modification of the arrangement as shown in Figure 3 ; and
- Figure 5: is a circuit diagram of a modification of the arrangement of Figure 1 that has an increased voltage rating

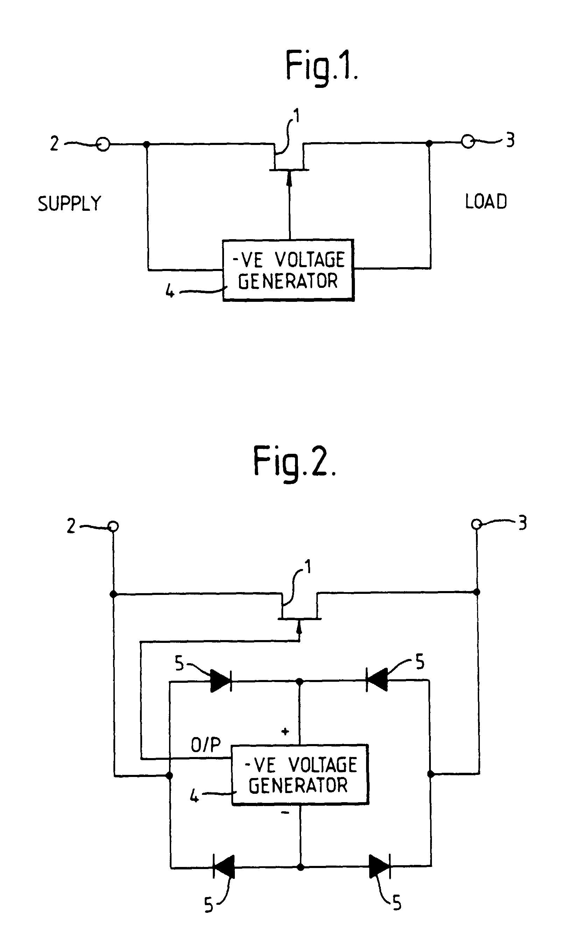

Referring to the accompanying drawings, Figure 1 shows a two-terminal circuit protection device for a d.c. circuit which comprises a depletion mode MOSFET or a JFET 1 that is series connected between the terminals 2 and 3, and a negative voltage generator 4 whose input is taken across the FET 1 and whose output is connected to the gate of the FET 1, so that, when the negative voltage generator operates, the gate-source voltage of the FET is approximately equal to the negative of its drain-source voltage.

In use the FET 1 is in its ON state during normal operation of the circuit, and the only voltage drop caused by the circuit protection arrangement is that caused by the FET channel resistance. Since the channel resistance is generally constant under normal conditions the protection arrangement is linear and acts like a small resistance in the line. If the arrangement is subjected to an overcurrent, the voltage drop across the FET will increase and thus the input voltage to the negative voltage generator 4 increases. At some stage the input of the negative voltage generator will be sufficient to cause it to generate an output at which stage the negative voltage generator will switch the FET off. Once this has occurred, it will remain latched in its OFF state until the power supply or the load has been disconnected, since even when the overcurrent passes the entire circuit voltage occurs across the FET and is fed back into its gate.

Figure 2 shows a modification of the circuit of Figure 1 which is suitable for use in an a.c. circuit. In this circuit a JFET 1 is still connected directly in the line of the circuit between the terminals 2 and 3, but the negative voltage generator 4 is located within a rectifying diode bridge that is formed from diodes 5 and that is connected across the JFET. The JFET 1 will pass current in either direction in normal operation while its gate is held below the threshold voltage of the JFET, and a rectified version of the signal voltage across the JFET is fed into its gate by the negative voltage generator. When the arrangement is subjected to an overcurrent the gate bias will increase so as to switch the JFET 1 OFF irrespective of the polarity of the overcurrent.

This arrangement has the advantage that since the diodes in the bridge are not series connected in the line they do not cause any cross-over distortion and the arrangement is linear. As with the arrangement shown in Figure 1, the only series resistance in the line is the channel resistance of JFET1. In addition, because the diodes do not pass load current, small signal diodes can be employed.

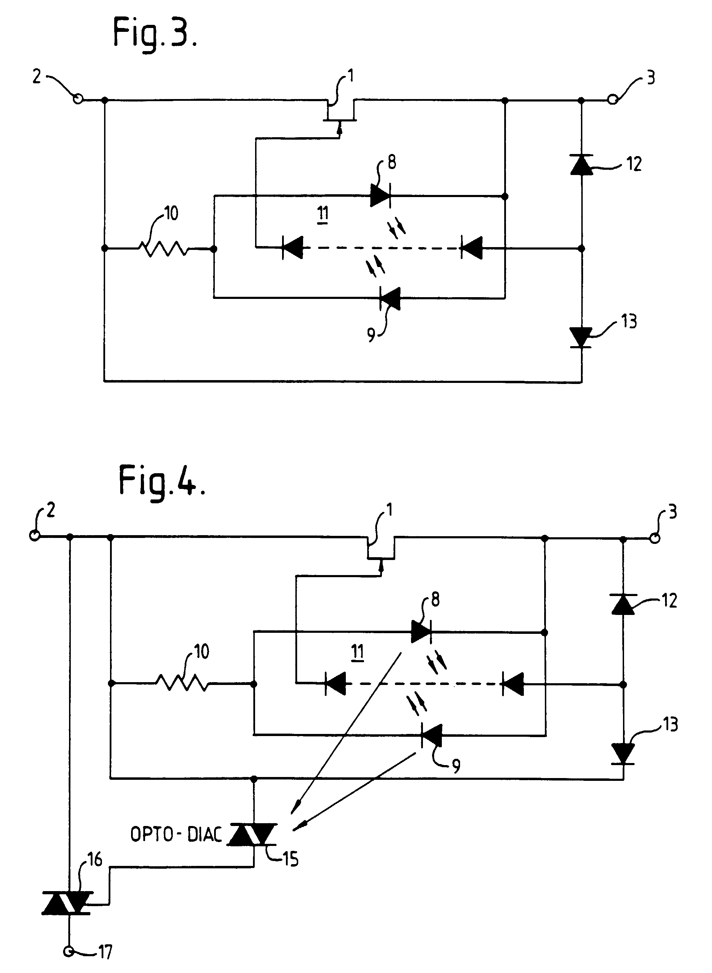

Figure 3 shows a further form of arrangement that is suitable for use in an a.c. circuit. In this arrangement a JFET 1 is connected in series in the line, and a pair of light-emitting diodes 8 and 9 are connected across the JFET 1, the LEDs 8 and 9 having opposite polarity. A resistor 10 may be connected in series with the LEDs 8 and 9 in order to provide a degree of freedom in determining at what level of overcurrent the LEDs will turn on and to limit the current through the LEDs. The LEDs 8 and 9 are optically coupled to a light sensitive diode array 11 connected in the photovoltaic mode to the gate of the JFET 1 at its cathode terminal and to a pair of back-to-back steering diodes 12 and 13 at its anode terminal, the diodes 12 and 13 spanning the JFET 1.

As with the other arrangements described above, the arrangement will conduct current in normal operation with no initial voltage drop occurring across the JFET 1, the only voltage drop occurring being that due to the channel resistance of the JFET. When the arrangement is subject to an overcurrent the increase in voltage across the JFET 1 will cause either LED 8 or LED 9 to light up depending on the polarity of the overcurrent and cause the light sensitive diode array 11 to bias the gate of JFET 1 negatively. As the gate bias increases the current through the JFET reduces until the gate bias exceeds the threshold voltage of the JFET whereupon the line current will approach zero. The increase in voltage across the JFET 1 in its off state will cause the gate bias to increase and the FET to be latched in its off state.

The purpose of the steering diodes 12 and 13 is to ensure that the voltage of the anode terminal of the photovoltaic diode array 11 does not rise above one diode voltage drop of whichever of terminals 2 and 3 has the lowest voltage. This ensures that when LED 8 or 9 lights up, the gate of JET 1 will be biased negatively with respect to whichever terminal of JFET 1 is acting as the source.

In a modification of the circuit, a current regulator, eg. a current regulating diode, may be included instead of resistance 10 or in series with it in order to ensure that excessive current does not flow through the LEDs 8 and 9 at high voltages.

Figure 4 shows a modification of the circuit shown in Figure 3 which is a three terminal device that will protect a circuit from an overcurrent and at the same time shunt the current across the load. This arrangement is constructed in the same way as that shown in Figure 3 but includes an opto-triac 15 that is optically coupled to the LEDs 8 and 9. One terminal of the opto-triac is connected to the circuit line and the other terminal is connected to the gate of a power triac 16 that is connected between the line and the earth terminal 17.

When a transient is experienced one of LEDs 8 and 9 lights up and causes the photovoltaic diode array to switch JFET 1 off, as described above. At the same time opto-triac 15 briefly shorts the gate of the power triac 16 to the circuit line, thereby turning the power triac on and shorting the transient across the circuit load.

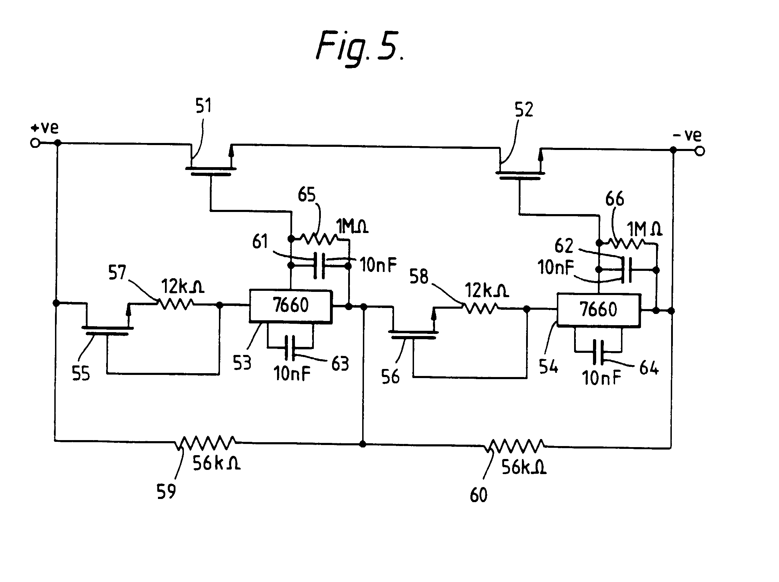

Figure 5 shows a circuit that employs a pair of series connected MOSFETS 51 and 52 for switching the line. Unfortunately the maximum voltage rating of readily available depletion mode transistors tend to be in the order of 200V, yet many higher voltage applications exist of reasonable current rating. The use of a pair of series connected transistors will halve the voltage drop across each transistor.

A pair of negative voltage generators 53 and 54 are series connected together and take their input voltage from the voltage drop across the two FETs 51 and 52, the output of each of the negative voltage generators being fed into the gate of one of the FETs. A pair of current limiting circuits formed from FETs 55 and 56 and resistors 57 and 58 limit the input current to the negative voltage generators 53 and 54 when an overcurrent is experienced.

It is important that both FETs 51 and 52 switch off at the same time in order that the voltage drop is evenly distributed over them and the voltage rating of each of the transistors is not exceeded. In order to ensure that this occurs, the node between the negative voltage generators 53 and 54 is held at a voltage mid way between the voltages on either side of the two FETs 51 and 52 by means of a voltage divider formed by resistors 59 and 60.

Capacitors 61 to 64 are employed to hold charge in the negative voltage generators 53 and 54, and, in combination with 1MΩ 65 and 66, reduce noise from the output of the negative voltage generators.

## Claims

1. An arrangement that exhibits a foldback characteristic and that is intended to be series connected in a line of an electrical circuit for protecting the circuit from an overcurrent, which comprises a depletion mode FET (1) that switches the line current and a control device (4) that is connected across a resistance in the line (2,3) and will bias the gate of the FET (1) in response to the voltage difference across the resistance in order to switch the FET off when the arrangement is subjected to an overcurrent in the line, the arrangement being a two terminal arrangement or one in which a third terminal switches on when an overcurrent is experienced in order to shunt the current across a load connected to the circuit or to shunt the current to an earth terminal.

2. An arrangement as claimed in claim 1, wherein the control device biases the gate in response to a voltage drop that occurs across the FET.

3. An arrangement as claimed in claim 2, which includes no resistive components series connected in the line other than the FET.

4. An arrangement as claimed in any one of claims 1 to 3, wherein the control device that biases the gate is a negative voltage generator (4).

5. An arrangement as claimed in any one of claims 1 to 3, wherein the control device that biases the gate comprises an opto-electronic coupling arrangement (8, 9, 11).

6. An arrangement as claimed in claim 5, wherein the opto-electronic coupling arrangement comprises a light source (8, 9) that is powered by the voltage drop in the line and which is optically coupled to a photovoltaic component (11) that is connected to the gate of the FET.

7. An arrangement as claimed in any one of claims 1 to 6, for operation in an a.c. line, wherein the control device is connected to the line via a rectifying bridge (5, 5, 5, 5,).

8. An arrangement as claimed in any one of claims 1 to 7, which has a maximum leakage current that is not more than one half the value of the trip current.

9. An arrangement as claimed in claim 8, wherein the maximum leakage current is not more than 0.1 times the trip current.

10. An arrangement as claimed in one of claims 1 to 9 which is a three-terminal arrangement.

11. An arrangement as claimed in claim 10 which draws no power from a circuit supply line.

12. An arrangement as claimed in claim 5 or claim 6 which is a three-terminal device in which the third terminal is optically coupled to the control device.

## Patentansprüche

1. Anordnung, die eine Rückregelungs-Charakteristik zeigt und dazu bestimmt ist, in Reihe in eine Leitung einer elektrischen Schaltung geschaltet zu werden, um die Schaltung vor einem Überstrom zu schützen, wobei die Anordnung einen Verarmungstyp-FET (1), der den Leitungsstrom schaltet, und eine Steuereinrichtung (4) aufweist, die parallel zu einem Widerstand in der Leitung (2, 3) geschaltet ist und den Gate-Anschluß des FET (1) in Abhängigkeit von der Spannungsdifferenz über dem Widerstand vorspannt, um den FET auszuschalten, wenn die Anordnung einem Überstrom in der Leitung ausgesetzt ist, wobei die Anordnung eine Anordnung mit zwei Anschlüssen oder eine solche ist, bei der ein dritter Anschluß einschaltet, wenn ein Überstrom auftritt, um den Strom im Nebenschluß durch eine mit der Schaltung verbundene Last zu leiten oder um den Strom im Nebenschluß zu einem Masseanschluß zu leiten.

2. Anordnung nach Anspruch 1,
wobei die Steuereinrichtung den Gate-Anschluß in Abhängigkeit von einem Spannungsabfall, der über dem FET auftritt, vorspannt.

3. Anordnung nach Anspruch 2,
die außer dem FET keine in die Leitung geschalteten ohmschen Komponenten aufweist.

4. Anordnung nach einem der Ansprüche 1 bis 3,
wobei die den Gate-Anschluß vorspannende Steuereinrichtung ein negativer Spannungsgenerator (4) ist.

5. Anordnung nach einem der Ansprüche 1 bis 3,
wobei die den Gate-Anschluß vorspannende Steuereinrichtung eine opto-elektronische Kopplungsanordnung (8, 9, 11) aufweist.

6. Anordnung nach Anspruch 5,
wobei die opto-elektronische Kopplungsanordnung eine Lichtquelle (8, 9) aufweist, die von dem Spannungsabfall in der Leitung gespeist wird und die mit einer Photovoltaik-Komponente (11), die mit dem Gate-Anschluß des FET verbunden ist, optisch gekoppelt ist.

7. Anordnung nach einem der Ansprüche 1 bis 6,
zum Betrieb in einer Wechselstromleitung, wobei die Steuereinrichtung mit der Leitung über eine Gleichrichterbrücke (5, 5, 5, 5) verbunden ist.

8. Anordnung nach einem der Ansprüche 1 bis 7,
die einen maximalen Leckstrom hat, der nicht größer als der halbe Wert des Auslösestroms ist.

9. Anordnung nach Anspruch 8,
wobei der maximale Leckstrom nicht mehr als das 0,1fache des Auslösestroms ist.

10. Anordnung nach einem der Ansprüche 1 bis 9, die eine Anordnung mit drei Anschlüssen ist.

11. Anordnung nach Anspruch 10,
die einer Versorgungsleitung der Schaltung keine Leistung entnimmt.

12. Anordnung nach Anspruch 5 oder Anspruch 6,
die eine Einrichtung mit drei Anschlüssen ist, bei der der dritte Anschluß mit der Steuereinrichtung optisch gekoppelt ist.

## Revendications

1. Système présentant une caractéristique de repliement et destiné à être connecté en série sur une ligne d'un circuit électrique pour protéger le circuit d'une surintensité, caractérisé en ce qu'il comprend un transistor (1) à effet de champ à déplétion qui commute le courant de ligne et un dispositif (4) de commande qui est connecté aux bornes d'une résistance de la ligne (2, 3) et polarise la grille du transistor (1) à effet de champ en réponse à la différence de tension aux bornes de la résistance, afin de faire passer le transistor à effet de champ à l'état non passant lorsque le système est soumis à une surintensité sur la ligne, le système étant un système à deux bornes ou un système dans lequel une troisième borne devient passante lorsqu'une surintensité apparaît, afin de court-circuiter le courant aux bornes d'une charge connectée au circuit ou de court-circuiter le courant vers une borne de terre.

2. Système selon la revendication 1, dans lequel le dispositif de commande polarise la grille en réponse à une chute de tension qui se produit aux bornes du transistor à effet de champ.

3. Système selon la revendication 2, qui ne comporte pas de composants résistifs connectés en série sur la ligne, autres que le transistor à effet de champ.

4. Système selon l'une quelconque des revendications 1 à 3, dans lequel le dispositif de commande qui polarise la grille est un générateur (4) de tension négative.

5. Système selon l'une quelconque des revendications 1 à 3, dans lequel le dispositif de commande qui polarise la grille comprend un système (8,9,11) de couplage optoélectronique.

6. Système selon la revendication 5, dans lequel le système de couplage optoélectronique comprend une source (8,9) lumineuse qui est alimentée par la chute de tension se produisant sur la ligne, et qui est couplée optiquement à un composant (11) photovoltaïque connecté à la grille du transistor à effet de champ.

7. Système selon l'une quelconque des revendications 1 à 6, destiné à fonctionner sur une ligne de courant alternatif, dans lequel le dispositif de commande est connecté à la ligne par l'intermédiaire d'un pont (5,5,5,5) de redressement.

8. Système selon l'une quelconque des revendications 1 à 7, qui présente un courant de fuite maximum ne dépassant pas la moitié de la valeur du courant de déclenchement.

9. Système selon la revendication 8, dans lequel le courant de fuite maximum ne dépasse pas 0,1 fois le courant de déclenchement.

10. Système selon l'une des revendications 1 à 9, celui-ci étant un système à trois bornes.

11. Système selon la revendication 10, qui ne prélève pas de puissance sur une ligne d'alimentation de circuit.

12. Système selon la revendication 5 ou 6, ce système étant un dispositif à trois bornes, dans lequel la troisième borne est couplée optiquement au dispositif de commande.
